# EUROPEAN PATENT APPLICATION

(11) **EP 4 687 349 A1**
(43) Date of publication of application: **04.02.2026**
(21) Application number: 25193252.1
(22) Date of filing: 31.07.2025
(51) Int. Cl.: H04Q 1/02

(54) **IMPROVEMENTS IN OR RELATING TO EQUIPMENT PACKAGES FOR TELECOMMUNICATIONS CABINETS**

(30) Priority: 02.08.2024 GB 202411411
(71) Applicant: Vodafone Group Services Limited, Newbury RG14 2FN (GB)
(72) Inventor: LAW, Alan, London, W2 6BY (GB); SOLANKY, Devang, London, W2 6BY (GB)
(74) Representative: Boult Wade Tennant LLP

(57) **Abstract**

An equipment package (1) for installation in a telecommunications cabinet (20) and methods of use thereof. The equipment package (1) comprising a bootable electronic device (3), a first air vent (4) at a first end (11) of the equipment package, a second air vent (5) at a second end (12) of the equipment package, a fan (6) operative to create an airflow through the equipment package between the first air vent and the second air vent, one or more temperature sensors (7) for sensing a temperature associated with the equipment package, and a controller (8) configured to selectively operate the fan in a first mode and in a second mode dependent on the temperature sensed by the one or more temperature sensors.

In the first mode the controller (8) is configured to operate the fan (6) to create an airflow through the equipment package (1) from the first vent air (4) to the second vent air (5), and in the second mode the controller (8) is configured to operate the fan (6) to create a reverse airflow through the equipment package (1) from the second air vent (5) to the first air vent (4).

## Description

### Field of the disclosure

The present disclosure relates to improvements in or relating to equipment packages for telecommunications cabinets. In particular, it relates to an equipment package for installation in a telecommunications cabinet, a telecommunications cabinet comprising an equipment package, a method of operating an equipment package installed in a telecommunications cabinet, and a cold-start boot up procedure for an equipment package of a telecommunications cabinet.

### Background to the Disclosure

Telecommunications street cabinets may be located in a wide variety of locations subject to a variety of environmental conditions. Such telecommunications street cabinets may have installed in them a variety of equipment, in particular telecommunication equipment. For example, a single cabinet may typically have installed therein a variety of equipment, for example, servers, baseband units, power supplies, transmission equipment, battery backup units, radio units, etc.

When a telecommunications street cabinet is subject to a power outage this can lead to shut down of the installed equipment, especially where the power outage is of sustained duration leading to exhaustion of any battery backup unit contained in the telecommunications cabinet. During cold weather this can lead to the equipment becoming very cold over time, even within the telecommunications street cabinet. In particular, the equipment temperature may drop below a recommended temperature operating range for the equipment. In such a situation the equipment may remain offline until the environmental temperature increases in order to allow the equipment to safely boot up. This can lead to significant periods of inoperability of the telecommunications street cabinet resulting in deleterious effects on telecommunication coverage and useability. One solution that has been proposed is the installation of dedicated heating elements within the telecommunications street cabinet to accelerate temperature recovery when power is restored. However this solution adds additional hardware and deployment costs to the installation and operation of telecommunications street cabinets.

Against this background, the present disclosure aims to provide an improved solution, or at least commercially relevant alternative, addressing in particular the problems of telecommunications cabinet power outages in cold environments, in particular as applied to telecommunications street cabinets.

### Summary of the Disclosure

In a first aspect the present disclosure provides an equipment package for installation in a telecommunications cabinet, the equipment package comprising:
a bootable electronic device;
a first air vent at a first end of the equipment package;
a second air vent at a second end of the equipment package;
a fan operative to create an airflow through the equipment package between the first air vent and the second air vent;
one or more temperature sensors for sensing a temperature associated with the equipment package; and
a controller configured to selectively operate the fan in a first mode and in a second mode dependent on the temperature sensed by the one or more temperature sensors;
wherein in the first mode the controller is configured to operate the fan to create an airflow through the equipment package from the first vent air to the second vent air; and in the second mode the controller is configured to operate the fan to create a reverse airflow through the equipment package from the second air vent to the first air vent.

Operating the equipment package selectively in the first mode or the second mode dependent on the sensed temperature enables more flexible thermal management of the equipment package.

By use of the first mode and the second mode of operation of the fan the controller is enabled to initially operate the fan in the second mode to warm the equipment package when the equipment package is initially cold and then switch to operate the fan in the first mode to cool the equipment package once the equipment package has heated up sufficiently.

For example, when needing to warm up the bootable electronic device from a cold condition the fan may be operated in a mode that draws into the equipment package the warmest available air, i.e. choosing to draw air in from either the first end or the second end of the equipment package as appropriate. Using the warmest available air reduces the time taken for the bootable electronic device to reach its boot threshold temperature which in turn reduces the time for the equipment package to come back on-line in a situation where it has shut down due to cold conditions.

The controller may be configured to operate the fan in the second mode when the temperature sensed by the one or more temperature sensors is below a first threshold temperature. This is particularly advantageous for addressing the problem of telecommunications cabinet power outages in cold environments. The first threshold temperature may be, for example, 5°C, 4°C, 3°C, 2°C, 1°C, 0°C, -1°C, -2°C, -3°C, -4°C, or - 5°C.

In some examples the first threshold temperature is associated with a boot threshold temperature of the bootable electronic device. The first threshold temperature may be the same as the boot threshold temperature of the bootable electronic device or may set above the boot threshold temperature by a fixed margin. For example, in a case where the boot threshold temperature of the bootable electronic device (e.g. the processor) is 0°C, the first threshold temperature may also be 0°C or may be offset by a positive margin of e.g. 1°C, 2°C, 3°C or more degrees, such that the first threshold temperature is set at +1°C, +°2, +3°C, etc.

The controller may be configured to operate the fan in the first mode when the temperature sensed by the one or more temperature sensors rises above a second threshold temperature. For example, to switch from operating in the second mode to operating in the first mode at the second threshold temperature. The second threshold temperature may in some examples be the boot threshold temperature of the bootable electronic device. In some examples the second threshold temperature may equal the first threshold temperature. In some other examples the second threshold temperature may be higher than the first threshold temperature so that, for example, the second mode of the fan remains operative for a period after the boot threshold temperature has been reached.

The second threshold temperature may be, for example, -5°C, -4°C, -3°C, -2°C, -1°C, 0°C, 1°C, 2°C, 3°C, 4°C, 5°C, 6°C, 7°C, 8°C, 9°C, 10°C or higher.

In one particular example, the first threshold temperature and the second threshold temperature are both set at 0°C. In another example, the first threshold temperature is set at 0°C and the second threshold temperature is set at 5°C. It will be understood that other temperatures for the first and second threshold temperatures may be set as required by the particular operating parameters of the equipment package.

Typically the second mode will be used as part of a cold-start boot up procedure of the equipment package when it is restarting following a power outage. Typically the first mode will be used during a normal operating mode of the equipment package when it is generating substantial internal heat from its components.

The one or more temperature sensors may be configured to sense one or more of an air temperature of air passing through the first air vent, an air temperature of air passing through the second air vent, a temperature of the bootable electronic device; or an environmental temperature outside the equipment package. In some examples it may be preferred to use the temperature of the bootable electronic device itself as providing the most accurate assessment of when the bootable electronic device reaches its boot threshold temperature. However, in other examples, the use of a temperature of the air entering or leaving the equipment package or an environmental temperature may be used as an analogue for or approximation of the temperature of the bootable electronic package.

The temperature of the bootable electronic device may be a temperature of a processor of the bootable electronic device, for example as measured by an internal temperature sensor of the processor.

The fan operative to create the airflow through the equipment package may comprise or consist of a single fan or multiple fans. In some examples the fan comprises or consists of a fan block comprising multiple fan units.

The first end and the second end of the equipment package may be at opposite ends of the equipment package.

Typically, equipment packages configured for installation in a telecommunications cabinet have a generally cuboid shape with a front end, rear end, upper face, lower face and two side walls.

The first end of the equipment package may be a front end configured to face a front door of a telecommunications cabinet when installed in said telecommunications cabinet. The second end of the equipment package may be a rear end configured to face a rear of a telecommunications cabinet when installed in said telecommunications cabinet.

The bootable electronic device may comprise a processor. The bootable electronic device may comprise other bootable elements, for example a network interface card, a memory board, etc.

The equipment package may comprise or consist of a server, router, switch, or other equipment requiring air cooling.

The server may be an edge server, for example a Commercial-Off-The-Shelf (COTS) server. Edge servers may be installed in telecommunications cabinets in a wide variety of locations and environments including remote and isolated locations.

The telecommunications cabinets may be telecommunications street cabinets, i.e. typically located in the open (i.e. not within a heated structure such as a building) rather than in a data centre. As such may be particularly prone to cold conditions in the event of a power outage. Beneficially, the use of the first mode and second mode of the present disclosure may be implemented in a server, for example a COTS server, without the addition of any additional hardware components.

The controller and/or the one or more temperature sensors may be on-board the server.

The controller may comprise or consist of a fan controller operative to control the fan of the equipment package.

In a second aspect the present disclosure provides a telecommunications cabinet comprising an equipment package as described above in the first aspect. The telecommunications cabinet may be a telecommunications street cabinet.

The telecommunications cabinet may comprise a housing having a front, comprising one or more doors for installing the equipment package into the telecommunications cabinet, and a rear. The rear may be enclosed, i.e. without access doors. However, one or more vents for ventilation may be provided in the housing at the rear of the telecommunications cabinet. The one or more doors at the front may be provided with one or more vents for ventilation.

The equipment package may be installed in the housing with the first air vent at the first end facing the one or more front doors and the second air vent at the second end facing the rear of the telecommunications cabinet.

In some examples the telecommunications cabinet comprises a plurality of equipment packages each as described above in the first aspect.

The telecommunications cabinet may optionally additionally have installed therein non-bootable equipment packages. The non-bootable equipment packages may include, for example power supplies, battery backup units, transmission units, etc. The non-bootable equipment packages may comprise fans configured to create a cooling air flow through the non-bootable equipment packages from their front face to their rear face so that heated air is discharged from their rear faces into the enclosed rear of the telecommunications cabinet.

The equipment packages may be arranged in a vertical stack within the telecommunications cabinet. The telecommunications cabinet may have more than one vertical stack of equipment packages, e.g. two or three vertical stacks that are arranged side-by-side each with their first ends facing the front of the telecommunications cabinet.

The non-bootable equipment packages, where present, may be arranged in the vertical stack(s) or elsewhere within the telecommunications cabinet. The non-bootable equipment packages may be located at a bottom of the vertical stack(s) or otherwise in a lower portion of the housing, e.g. at or towards a bottom of the telecommunications cabinet.

In the first mode air is drawn into and through an equipment package with the air being sourced from the front of the telecommunications cabinet (e.g. air that has entered the telecommunication cabinet from the outside through the vents in the front door(s)). This air will be relatively cold.

By contrast, in the second mode air is drawn into and through an equipment package with that air being sourced from the rear of the telecommunications cabinet. This air will be relatively warm (despite the optional presence of vents in the rear of the telecommunications cabinet) since, following restoration of power to the telecommunications cabinet, the non-bootable equipment packages will start to come online and expel heated air towards the enclosed rear of the telecommunications cabinet. Even where other heat sources such as the non-bootable equipment packages are not present, the rear of the telecommunications cabinet will typically be warmer than the front due to its enclosed geometry.

Each equipment package may comprise its own controller operable to selectively operate the fan of its equipment package in the first mode and in the second mode independent of the operating mode of the other equipment packages. This enables more flexible and efficient thermal management of the equipment packages within the telecommunications cabinet, since each equipment package can switch from the warming effect of the second mode to the cooling effect of the first mode dependent on the actual temperature affecting that equipment package. This may be particularly desirable with vertical stacks of equipment packages where the air temperature in the enclosed rear may vary (being generally hotter at the top than the bottom) meaning that the temperature of the air drawn into the second air vent of each equipment package may vary over time dependent upon its vertical location within the vertical stack. For example, equipment packages located at the top of the vertical stack will generally reach their boot threshold temperature fastest.

In a third aspect the present disclosure provides a method of operating an equipment package installed in a telecommunications cabinet, the method comprising:
selectively operating a fan of the equipment package:
   - in a first mode to create an airflow through the equipment package from a first air vent located at a first end of the equipment package to a second air vent located at a second end of the equipment package, and
   - in a second mode to create a reverse airflow through the equipment package from the second air vent to the first air vent; and
determining whether to operate the fan in the first mode or the second mode dependent on a temperature associated with the equipment package.

The method may comprise determining to operate the fan in the second mode when the temperature is:
- below a first threshold temperature; and/or
- below a boot threshold temperature of a bootable electronic device contained within the equipment package; and/or
- below 0°C, optionally below -5°C.

The temperature associated with the equipment package may be one or more of an air temperature of air passing through the first air vent, an air temperature of air passing through the second air vent, a temperature of a bootable electronic device contained within the equipment package; or an internal temperature of the telecommunications cabinet.

The telecommunications cabinet may comprise a housing having a front, comprising one or more doors for installing the equipment package into the telecommunications cabinet, and a rear. The rear may be enclosed, i.e. without access doors. The equipment package may be installed in the housing with the first air vent at the first end facing the one or more front doors and the second air vent at the second end facing the rear of the telecommunications cabinet;
such that in the first mode air from outside the telecommunications cabinet is drawn in through the first air vent and is expelled from the second air vent towards the rear of the telecommunications cabinet, and
in the second mode air from the rear of the telecommunications cabinet is drawn in through the second air vent and is expelled towards from the first air vent towards the front of the telecommunications cabinet.

The telecommunications cabinet may be a telecommunications street cabinet.

The bootable electronic device may comprise a processor. The bootable electronic device may comprise other bootable elements, for example a network interface card, a memory board, etc.

The controller and/or the one or more temperature sensors may be on-board the equipment package, e.g. a server.

In some examples a plurality of equipment packages are installed in the telecommunications cabinet, wherein each equipment package selectively operates its fan in the first mode or in the second mode independent of the operating mode of the other equipment packages.

The equipment package or equipment packages may be equipment packages as described above in the first aspect. The telecommunications cabinet may be a telecommunications cabinet as described above in the second aspect.

In a fourth aspect the present disclosure provides a cold-start boot up procedure for an equipment package of a telecommunications cabinet, the procedure comprising the steps of:
a) sensing a temperature associated with the equipment package;
b) determining that the sensed temperature is below a boot threshold temperature of a bootable electronic device of the equipment package;
c) based on said sensed temperature determination, operating a fan of the equipment package in a reverse mode such that air from a rear of the telecommunications cabinet is drawn through the equipment package to warm up the bootable electronic device, with the air being expelled from the equipment package towards a front of the telecommunications cabinet; and
d) booting up the bootable electronic device once the temperature associated with the equipment package reaches the boot threshold temperature.

The cold-start boot up procedure may further comprise the step of:
e) switching the fan to operate in a normal mode after the sensed temperature reaches the boot threshold temperature such that air from the front of the telecommunications cabinet is drawn through the equipment package to cool the bootable electronic device, with the air being expelled from the equipment package towards the rear of the telecommunications cabinet.

Relatively warm air from the rear of the telecommunications cabinet may in this way be used to more quickly and efficiently warm up the bootable electronic device from a cold condition. Using the warmest available air reduces the time taken for the bootable electronic device to reach its boot threshold temperature which in turn reduces the time for the equipment package to come back on-line in a situation where it has shut down due to cold conditions.

The telecommunications cabinet may be a telecommunications street cabinet.

It will be understood that features and advantages described above as part of one aspect are applicable to the other described aspects unless the context clearly requires otherwise.

### Brief Description of the Drawings

One or more embodiments of the disclosure will now be described, by way of example only, with reference to the accompanying drawings in which:
Figure 1 is a schematic perspective view of an equipment package according to the present disclosure operating in a first mode;
Figure 2 is a schematic perspective view of the equipment package of Figure 1 operating in a second mode;
Figure 3 is a schematic perspective view of a telecommunications cabinet according to the present disclosure having installed therein a plurality such equipment packages;
Figure 4 is a schematic side view of the telecommunications cabinet of Figure 3 with four equipment packages operating in their second mode;
Figure 5 a schematic side view of the telecommunications cabinet of Figure 3 with two equipment packages operating in their second mode and two equipment packages operating in their first mode; and
Figure 6 is a flowchart of a cold-start boot up procedure for an equipment package of a telecommunications cabinet according to the present disclosure.

### Detailed Description

Unless defined otherwise, all technical and scientific terms used in this specification have the same meaning as is commonly understood by the reader skilled in the art to which the claimed subject matter belongs. It is to be understood that the foregoing summary of the disclosure and the following examples are exemplary and explanatory only and are not restrictive of any subject matter claimed.

The following description is directed to one or more embodiments of the disclosure. The description of the embodiments is not meant to include all the possible embodiments of the disclosure that are claimed in the appended claims. Many modifications, improvements and equivalents which are not explicitly recited in the following embodiments may fall within the scope of the appended claims. Features described as part of one embodiment may be combined with features of one or more other embodiments unless the context clearly requires otherwise.

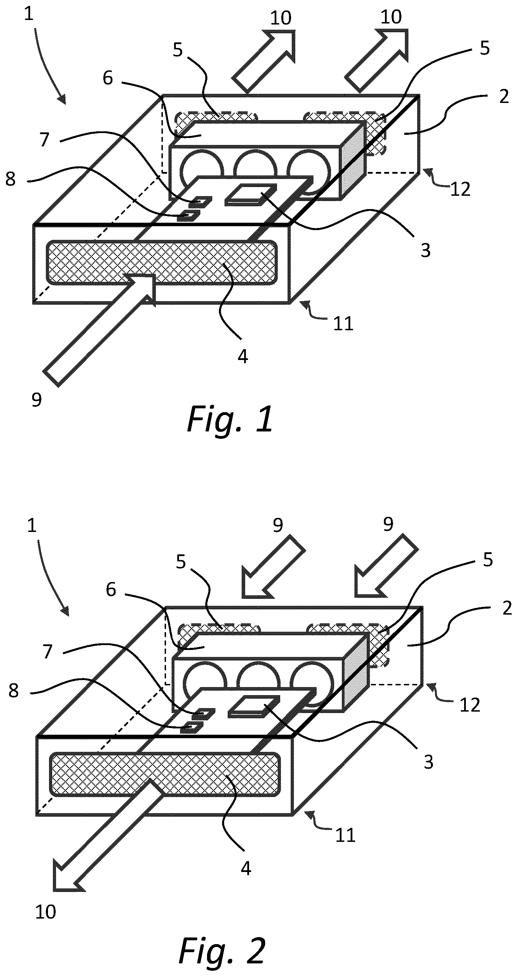

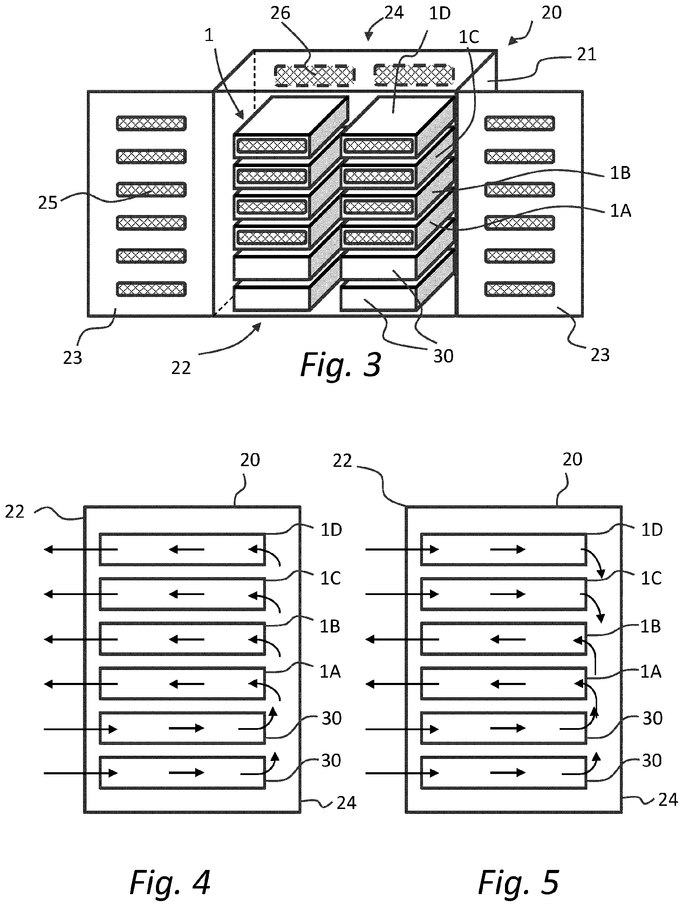

Figure 1 shows an equipment package 1 for installation in a telecommunications cabinet 20 (shown in Figure 3). The telecommunications cabinet 20 may be a telecommunications street cabinet. The equipment package 1 comprises a bootable electronic device 3, a first air vent 4 at a first end 11 of the equipment package 1 and a second air vent 5 at a second end 12 of the equipment package 1. The first air vent 4 and/or the second air vent 5 may comprises one or more apertures, grills, meshes, etc as known in the art that enable air flows to pass therethrough. The air vents may be open or may be provided with means for filtering particles such as dust.

In some examples the bootable electronic device 3 comprises a processor. In some examples the equipment package 1 comprises or consists of a server, optionally an edge server, for example a COTS server.

A fan 6 is provided that is operative to create an airflow through the equipment package 1 between the first air vent 4 and the second air vent 5. The fan 6 may comprise or consist of a single fan or multiple fans. In some examples the fan 6 comprises or consists of a fan block comprising multiple fan units.

One or more temperature sensors 7 are provided for sensing a temperature associated with the equipment package 1. In Figure 1 the temperature sensor(s) 7 are shown schematically separate from the bootable electronic device 3. Alternatively, the one or more temperature sensors 7 may be located elsewhere within the equipment package 1 and may, in some examples comprise or consist of an internal temperature sensor of the bootable electronic device 3, e.g. a digital temperature sensor of a processor. Additionally or alternatively one or more temperature sensors 7 may be located in the vicinity of the first air vent 4 and/or the second air vent 5.

The one or more temperature sensors 7 may be configured to sense one or more of an air temperature of air passing through the first air vent 4, an air temperature of air passing through the second air vent 5, a temperature of the bootable electronic device 3; or an environmental temperature outside the equipment package 1.

A controller 8 is provided configured to selectively operate the fan 6 in a first mode (Figure 1) and in a second mode (Figure 2) dependent on the temperature sensed by the one or more temperature sensors 7. In Figure 1 the controller 8 is shown schematically separate from the bootable electronic device 3. However, in some examples the controller 8 may form a part of the bootable electronic device 3. The controller 8 may be distributed across one or more components of the equipment package 1. The controller 8 may comprise functional units for controlling the bootable electronic device 3 and the fan 6 that may be integrated or distributed.

In the first mode, as shown in Figure 1, the controller 8 is configured to operate the fan 6 to create an airflow through the equipment package from the first vent air 4 to the second vent air 5. An airflow, shown by arrow 9, is drawn in through the first air vent 4 at the first end 11. The airflow passes over and around the bootable electronic device 3 and is then expelled through the second air vent 5 at the second end 12, as shown by arrows 10.

In the second mode, as shown in Figure 2, the controller 8 is configured to operate the fan 6 to create a reverse airflow through the equipment package 1 from the second air vent 5 to the first air vent 4. As shown by the arrows 9 and 10 the direction of the airflow through the equipment package 1 is reversed in the second mode compared to the first mode.

The controller 8 may be configured to operate the fan 6 in the second mode when the temperature sensed by the one or more temperature sensors 7 is below a first threshold temperature. The first threshold temperature may be a boot threshold temperature of the bootable electronic device 3. The first threshold temperature may be, for example, 5°C, 4°C, 3°C, 2°C, 1°C, 0°C, -1°C, -2°C, -3°C, -4°C, or -5°C.

The controller may also be configured to operate the fan 6 in the first mode when the temperature sensed by the one or more temperature sensors 7 rises above a second threshold temperature.

The second threshold temperature may be, for example, -5°C, -4°C, -3°C, -2°C, -1°C, 0°C, 1°C, 2°C, 3°C, 4°C, 5°C, 6°C, 7°C, 8°C, 9°C, 10°C or higher. The second threshold temperature may in some examples be the boot threshold temperature of the bootable electronic device 3, i.e. equal to the first threshold temperature. As an example, the boot threshold temperature may be approximately -5°C to 0°C for an equipment package 1 in the form of an edge server.

As shown in Figure 3, the equipment package 1 is installable in a telecommunications cabinet 20.

As shown in Figure 3, the telecommunications cabinet 20 comprises a housing 21 having a front 22, comprising one or more doors 23 for installing the equipment package into the telecommunications cabinet 20, and a rear 24. The rear 24 may be enclosed, i.e. with no access doors such that access to install and/or remove the equipment packages 1 is solely via the doors 23 at the front 22. Rear ventilation vents 26 may be provided in the rear 24 if required. Front ventilation vents 25 may also be provided if required in the front doors 23.

A plurality of equipment packages 1 may be installed within the telecommunications cabinet 20, optionally in one or more vertical stacks as shown in Figure 3. In the illustrated example the right-hand stack is provided with four equipment packages 1A-1D, with equipment package 1D at the top and 1A towards the bottom.

In addition, two non-bootable equipment packages 30 are provided at the bottom of the vertical stack below equipment package 1A. The non-bootable equipment packages 30 comprise equipment such as battery back up units and power supplies that generate heat when powered on but not requiring booting up when power is initially established.

In use, during operation of the equipment package 1 in the telecommunications cabinet 20, the controller 8 operates to selectively operate the fan 6 in the first mode to create an airflow through the equipment package 1 from the first air vent 4 to the second air vent 5 and in the second mode to create a reverse airflow through the equipment package 1 from the second air vent 5 to the first air vent 4. The controller 8 determines whether to operate the fan 6 in the first mode or the second mode dependent on a temperature associated with the equipment package 1, for example as sensed by the temperature sensor(s) 7.

The equipment packages 1 are installed in the housing 21 with the first air vent 4 at the first end 11 facing the one or more front doors 23 and the second air vent 5 at the second end 12 facing the rear 24. As such the first end 11 forms the front end and the second end 12 forms the rear end of the equipment package 1.

Following a power outage, on restoration of power the rear 24 of the telecommunications cabinet 20 will typically heat up faster that the front 22 due to the heated airflows expelled rearwards by the non-bootable equipment packages 30. Consequently, in some examples the controller 8 determines to operate the fan 6 in the second mode when the temperature is below the first threshold temperature and/or is below the boot threshold temperature of the bootable electronic device 3 contained within the equipment package 1. This enables relatively warm air from the rear 24 of the housing 21 to be drawn over the bootable electronic device 3 accelerating the warming of the device and reducing the time needed to reach the boot threshold temperature compared to flowing relatively cold air from the front 22 of the housing 21 into the equipment packages 1.

Each equipment package 1 within the telecommunications cabinet 20 may selectively operate its fan 6 in the first mode or in the second mode independent of the operating mode of the other equipment packages 1. For example, Figure 4 shows schematically one vertical stack consisting of four equipment packages 1A -1D stacked on top of two non-bootable equipment packages 30 shortly after restoration of power. The two non-bootable equipment packages 30 (for example a power supply unit and a battery back-up unit) are powered on, are generating heat and have internal fans that are expelling heated air rearwards towards the rear 24 as illustrated by the arrows. At the same time all four of the equipment packages 1A to 1D are below the boot threshold temperature of their processors and are operating in the second mode with the air being drawn in from the rear 24 and expelled forwards towards the front 22 in order to warm their bootable electronic devices 3 using the air warmed by the heat exhausted from the non-bootable equipment packages 30.

Figure 5 illustrates the situation a short time later by which point the temperature within the top two equipment packages 1D and 1C has risen above the boot threshold temperature. Consequently, these equipment packages 1 have switched to the first mode of operation with their fans 6 now driving air rearwards. Equipment packages 1B and 1A are still below the boot threshold temperature and are still operating in the second mode of operation.

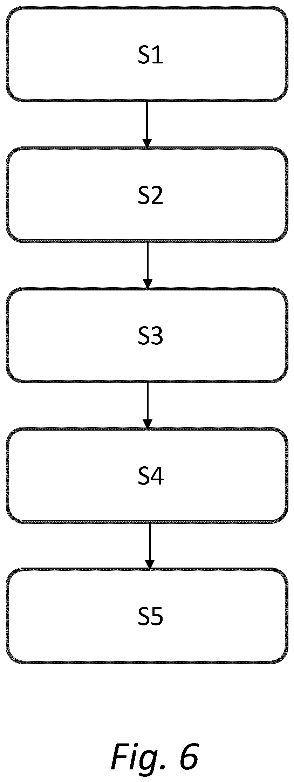

The present disclosure finds particular application during a cold-start boot up procedure of the equipment package 1. Figure 6 shows a flow chart of the cold-start boot up procedure.

Step S1 comprises sensing a temperature associated with the equipment package 1.

Step S2 comprises determining that the sensed temperature is below a boot threshold temperature of the bootable electronic device 3 of the equipment package 1.

Step S3 comprises, based on said sensed temperature determination, operating the fan 6 of the equipment package 1 in a reverse mode such that air from the rear 24 of the telecommunications cabinet 20 is drawn through the equipment package 1 to warm up the bootable electronic device 3, with the air being expelled from the equipment package 1 towards the front 22 of the telecommunications cabinet 20.

Step S4 comprises booting up the bootable electronic device 3 once the temperature associated with the equipment package 1 reaches the boot threshold temperature.

Optional step S5 comprises switching the fan 6 to operate in a normal mode after the sensed temperature reaches the boot threshold temperature such that air from the front 22 of the telecommunications cabinet 20 is drawn through the equipment package 1 to cool the bootable electronic device 3, with the air being expelled from the equipment package 1 towards the rear 24 of the telecommunications cabinet 20.

## Claims

1. An equipment package for installation in a telecommunications cabinet, the equipment package comprising:
a bootable electronic device;
a first air vent at a first end of the equipment package;
a second air vent at a second end of the equipment package;
a fan operative to create an airflow through the equipment package between the first air vent and the second air vent;
one or more temperature sensors for sensing a temperature associated with the equipment package; and
a controller configured to selectively operate the fan in a first mode and in a second mode dependent on the temperature sensed by the one or more temperature sensors;
wherein in the first mode the controller is configured to operate the fan to create an airflow through the equipment package from the first vent air to the second vent air; and
in the second mode the controller is configured to operate the fan to create a reverse airflow through the equipment package from the second air vent to the first air vent.

2. The equipment package of claim 1, wherein the controller is configured to operate the fan in the second mode when the temperature sensed by the one or more temperature sensors is below a first threshold temperature;
and optionally:
wherein the first threshold temperature is a boot threshold temperature of the bootable electronic device.

3. The equipment package of any preceding claim, wherein the controller is configured to operate the fan in the first mode when the temperature sensed by the one or more temperature sensors rises above a second threshold temperature;
and optionally:
wherein the second threshold temperature is a boot threshold temperature of the bootable electronic device.

4. The equipment package of any preceding claim, wherein the one or more temperature sensors is configured to sense one or more of an air temperature of air passing through the first air vent, an air temperature of air passing through the second air vent, a temperature of the bootable electronic device; or an environmental temperature outside the equipment package;
and optionally:
wherein the temperature of the bootable electronic device is a temperature of a processor of the bootable electronic device.

5. The equipment package of any preceding claim, wherein the first end of the equipment package is a front end configured to face a front door of a telecommunications cabinet when installed in said telecommunications cabinet, and the second end of the equipment package is a rear end configured to face a rear of a telecommunications cabinet when installed in said telecommunications cabinet.

6. The equipment package of any preceding claim, wherein the bootable electronic device comprises a processor.

7. The equipment package of any preceding claim, wherein the equipment package comprises or consists of a server, optionally an edge server;
and optionally:
wherein the controller and/or the one or more temperature sensors are on-board the server.

8. A telecommunications cabinet comprising an equipment package as claimed in any preceding claim.

9. The telecommunications cabinet of claim 8, wherein the telecommunications cabinet comprises a housing having a front, comprising one or more doors for installing the equipment package into the telecommunications cabinet, and a rear;
the equipment package being installed in the housing with the first air vent at the first end facing the one or more front doors and the second air vent at the second end facing the rear of the telecommunications cabinet; and/or
wherein the telecommunications cabinet comprises a plurality of equipment packages each as claimed in any of claims 1 to 7, optionally arranged in a vertical stack, and wherein each equipment package comprises its own controller operable to selectively operate the fan of its equipment package in the first mode and in the second mode independent of the operating mode of the other equipment packages.

10. A method of operating an equipment package installed in a telecommunications cabinet, the method comprising:
selectively operating a fan of the equipment package:
- in a first mode to create an airflow through the equipment package from a first air vent located at a first end of the equipment package to a second air vent located at a second end of the equipment package, and
- in a second mode to create a reverse airflow through the equipment package from the second air vent to the first air vent; and
determining whether to operate the fan in the first mode or the second mode dependent on a temperature associated with the equipment package.

11. The method of claim 10, comprising determining to operate the fan in the second mode when the temperature is:
- below a first threshold temperature; and/or
- below a boot threshold temperature of a bootable electronic device contained within the equipment package; and/or
- below 0°C, optionally below -5°C.

12. The method of claim 10 or claim 11, wherein the temperature associated with the equipment package is one or more of an air temperature of air passing through the first air vent, an air temperature of air passing through the second air vent, a temperature of a bootable electronic device contained within the equipment package; or an internal temperature of the telecommunications cabinet; and/or
wherein the telecommunications cabinet comprises a housing having a front, comprising one or more doors for installing the equipment package into the telecommunications cabinet, and a rear;
the equipment package being installed in the housing with the first air vent at the first end facing the one or more front doors and the second air vent at the second end facing the rear of the telecommunications cabinet;
such that in the first mode air from outside the telecommunications cabinet is drawn in through the first air vent and is expelled from the second air vent towards the rear of the telecommunications cabinet, and
in the second mode air from the rear of the telecommunications cabinet is drawn in through the second air vent and is expelled towards from the first air vent towards the front of the telecommunications cabinet.

13. The method of any one of claims 10 to 12, wherein the bootable electronic device comprises a processor;
and optionally:
wherein the controller and/or the one or more temperature sensors are on-board the equipment package, e.g. a server.

14. The method of any one of claims 10 to 13, wherein a plurality of equipment packages are installed in the telecommunications cabinet, wherein each equipment package selectively operates its fan in the first mode or in the second mode independent of the operating mode of the other equipment packages; and/or
wherein the equipment package or equipment packages are equipment packages according to any one of claims 1 to 7.

15. A cold-start boot up procedure for an equipment package of a telecommunications cabinet, the procedure comprising the steps of:
a) sensing a temperature associated with the equipment package;
b) determining that the sensed temperature is below a boot threshold temperature of a bootable electronic device of the equipment package;
c) based on said sensed temperature determination, operating a fan of the equipment package in a reverse mode such that air from a rear of the telecommunications cabinet is drawn through the equipment package to warm up the bootable electronic device, with the air being expelled from the equipment package towards a front of the telecommunications cabinet; and
d) booting up the bootable electronic device once the temperature associated with the equipment package reaches the boot threshold temperature;
and optionally further comprising the step of:
e) switching the fan to operate in a normal mode after the sensed temperature reaches the boot threshold temperature such that air from the front of the telecommunications cabinet is drawn through the equipment package to cool the bootable electronic device, with the air being expelled from the equipment package towards the rear of the telecommunications cabinet.
